# EUROPÄISCHE PATENTSCHRIFT

(11) **EP 1 803 049 B1**
(45) Veröffentlichungstag und Bekanntmachung des Hinweises auf die Patenterteilung: **06.10.2010**
(21) Anmeldenummer: 05767842.7
(22) Anmeldetag: 08.07.2005
(51) Int. Cl.: G06F 1/20, H01L 23/473, F04D 13/02

(54) **W[RMETAUSCHSYSTEM**
HEAT EXCHANGE SYSTEM
SYSTEME ECHANGEUR DE CHALEUR

(30) Priorität: 08.07.2004 DE 102004033063
(43) Veröffentlichungstag der Anmeldung: 04.07.2007
(73) Patentinhaber: Hertweck, Jürgen, 76327 Pfinztal (DE)
(72) Erfinder: Hertweck, Jürgen, 76327 Pfinztal (DE)
(74) Vertreter: Geitz Truckenmüller Lucht
(86) Internationale Anmeldenummer: PCT/DE2005/001217
(87) Internationale Veröffentlichungsnummer: WO 2006/005325

(56) Entgegenhaltungen:
- EP-A- 0 582 217
- DE-A1- 10 344 699
- US-A1- 2003 209 343
- US-A1- 2004 123 614
- US-B1- 6 327 145
- US-B1- 6 600 649

## Beschreibung

Die Erfindung betrifft ein Wärmetauschsystem für elektronische Geräte, vorzugsweise Datenverarbeitungsgeräte, mit Hochleistungsprozessoren bzw. mit einer hohen Prozessordichte, mit wenigstens einem Primärkühlkreis und wenigstens einem Sekundärkühlkreis, die derart thermisch gekoppelt sind, dass die vom Sekundärkühlkreis aufgenommene Wärme, vorzugsweise Prozessorabwärme, im Wege des Wärmetauschs über eine Kontaktfläche zumindest weitgehend an den oder die Primärkühlkreis(e) abgegeben wird bzw. werden und mittels des bzw. der Primärkühlkreis(e) abgeführt und/oder abgekühlt wird bzw. werden.

Ein derartiges Flüssigkeitskühlsystem für sogenannte "Racks" ist seit kurzem von der Firma Rittal unter der Bezeichnung "PCS - Power Cooling System" am Markt erhältlich. Es handelt sich dabei um ein flüssigkeitsgekühltes System mit einem Primär- und einem Sekundärkreislauf, wobei eine Mini-Rückkühlanlage über eine Wasserzufuhr mit entsprechender Verbindungstechnik, also insbesondere über eine tropffreie Schnellverschlusskupplung, und einen entsprechenden Kühlkreisverteiler zum Anschluss mehrerer Kühlkreisläufe an eine einzige Kühlanlage angekoppelt werden. Auch hier kann von einem Primärkühlkreis oder zumindest einem Vorlauf und einem Rücklauf gesprochen werden.

Aus dem US-Patent US 6,600,649 B1 ist darüber hinaus bekannt, ein Flüssigkeitskühlsystem, indem die Flüssigkeit mit einer mehrkammerigen Pumpe angetrieben wird, und ein Luftkühlkreislauf mit einem Kühlelement, dem ein Ventilator zugeordnet ist, thermisch hintereinander zu schalten. Dabei sind der Pumpantrieb und der Ventilatorantrieb auf einer gemeinsamen Welle angeordnet- Die Pumprotoren der Kammer sind induktiv derart gekoppelt, dass es genügt eine der beiden Pumpkammern mechanisch anzutreiben.. Als Antrieb ist ein Elektromotor vorgesehen.

Aufgrund des derzeitigen Trends, immer größere Prozessorleistungen auf immer kleinerem Raum anzuordnen, wie beispielsweise im Zusammenhang mit den vorstehend erwähnten "Rack-Servern", ist der Kühlungsbedarf in diesem Bereich derart drastisch gestiegen, dass die in diesem Bereich bislang vorwiegend eingesetzte Strömungsluftkühlung an ihre Grenzen stößt. Bei modernen Prozessoren müssen heute bis zu 70 W/cm² abgekühlt werden. Es handelt sich hierbei um eine Heizleistung, die mehreren Herdplatten entspricht, so dass die bislang übliche Konvektionskühlung schon aufgrund der begrenzten Wärmeaufnahmekapazität von Luft beschränkt ist. Hierzu müssen immer schnellere und leistungsstärkere Lüfter eingesetzt werden, wobei aufgrund der erhöhten Strömungsgeschwindigkeit der Luft, aber auch aufgrund der Lüfter selbst eine erhebliche Geräuschentwicklung unvermeidbar ist. Darüber hinaus gelten derartige Lüfterelemente als störanfällig.

Aus diesem Grunde setzen sich zumindest im professionellen Bereich von Hochleistungsrechnern zunehmend Flüssigkeitskühlsysteme durch, deren entscheidender Vorteil vor allem in der um 10-er Potenzen höheren Wärmeaufnahmekapazität der eingesetzten Kühlmittel im Vergleich zu Luft besteht.

Die derzeit im Markt befindlichen Systeme arbeiten im Wesentlichen mit einem Primärkühlkreislauf und einem Sekundärkühlkreislauf, wobei der Sekundärkühlkreislauf dem eigentlichen Rack zugeordnet ist und dort die über dem Primärkühlkreislauf abzuführende Wärme aufnimmt. Im Primärkühlkreislauf oder Vorlauf ist in der Regel der Antrieb für das in den Kreisläufen angeordnete Kühlmittel befindlich. Dieser Antrieb ist zumeist zentral außerhalb des Racks angeordnet, so dass grundsätzlich das Problem besteht, die Kühlflüssigkeit in ein Rack oder ein Chassis einzubringen. Dies gelingt in erster Linie mit flüssigkeitsdichten Schlauchkupplungen, die mehr oder minder tropfdicht geführt sind. Es versteht sich, dass die Bedienung derartiger Systeme einigermaßen umständlich ist und insbesondere ein schneller Austausch von Prozessoreinschüben hierdurch erschwert ist. Außerdem muss davon ausgegangen werden, dass die Kühlmittel überwiegend toxisch oder zumindest umweltschädlich sind, so dass die Akzeptanz dieser Systeme bislang noch als verhältnismäßig gering bezeichnet werden muss.

Ausgehend von diesem Stand der Technik liegt der Erfindung die Aufgabe zugrunde, ein stark vereinfachtes und kundenfreundlicheres Wärmetauschsystem für elektronische Geräte, insbesondere Datenverarbeitungsgeräte, mit Hochleistungsprozessoren bzw. mit hoher Prozessordichte zu schaffen.

Diese Aufgabe wird durch ein Wärmetauschsystem gemäß Hauptanspruch gelöst. Vorteilhafte Ausgestaltungen können den Ansprüchen 2 bis 16 entnommen werden.

Gemäß Hauptanspruch sind der Primärkühlkreis und der Sekundärkühlkreis miteinander thermisch gekoppelt, aber der Antrieb des Kühlmittels im Sekundärkühlkreis ausschließlich mittels magnetischer oder mechanischer Kopplung bewerkstelligt. Dies hat den entscheidenden Vorteil, dass der Sekundärkühlkreis als vollständig geschlossenes, vom Primärkühlkreis unabhängiges System ausgebildet werden kann. Die beiden Kühlkreise sind also strömungstechnisch vollständig voneinander getrennt und können daher beide separat abgedichtet werden. Im Falle der induktiven Kopplung sind die beiden Systeme sogar vollständig geschlossen ausgebildet. Im Falle der mechanischen Kopplung muss lediglich die Stelle der mechanischen Einkopplung der Energie für den Strömungsantrieb des Sekundärkühlkreislaufs, etwa mit eine Wellendichtung gedichtet werden. In beiden Fällen besteht der Vorteil dass der Strömungsantrieb für beide Kühlkreisläufe mit seinen bewegten und daher ggf. zu wartenden oder zu reparierenden Teilen nicht im Sekundärkühlkreislauf und somit zumeist außerhalb der eigentlichen Datenverarbeitungseinrichtung angeordnet ist. Dies ist insbesondere deshalb wichtig weil die Verwendung von Kühlflüssigkeiten in der extrem flüssigkeitsempfindlichen Datenverarbeitungseinheiten immer noch als erhebliches Risiko angesehen wird. Die Verlagerung von zu wartenden Teilen mit der Maßgabe dass das Kühlsystem im Bereich dieser Teile ggf. geöffnet werden muss, nach außerhalb stellt also einen nicht zu unterschätzenden Sicherheitsvorteil gegen über den vorbekannten Anlagen dar.

Der Verzicht auf einen aktiven Strömungsantrieb im Sekundärkühlkreis stellt überdies eine wesentliche Kostenersparnis dar. Außerdem können auf diese Weise die Sekundärkühlkreise mit den zu kühlenden Prozessoreinheiten fest verbunden und mit diesen bedarfsweise in Form von Einschubelementen eingesteckt und gegebenenfalls wieder aus dem Rack herausgenommen werden.

Gemäß Anspruch 2 ist der Sekundärkühlkreis als vollständig geschlossenes System ohne eigenen Strömungsantrieb ausgelegt. Der Sekundärkühlkreis benötigt daher weder Anschlüsse für das in dem Sekundärkühlkreis zirkulierende Kühlmittel noch eine eigene Spannungsversorgung, etwa zum Antrieb der in dem Kühlkreis zu befördernden Kühlmittel.

Gemäß Anspruch 3 ist, wie bereits erwähnt, der Sekundärkühlkreis als separates Einschubelement oder als integraler Bestandteil eines Einschubs einer oder mehrerer Prozessoreinheit(en) für ein Rack ausgebildet.

In konkreter Ausgestaltung ist in dem Primärkühlkreis eine vom Strömungsantrieb des Primärkühlkreises angetriebene Primärturbine mit einem Kopplungselement angeordnet, wobei mittels des erwähnten Kopplungselement eine magnetische Kopplung mit den Sekundärkühlkreis derart erfolgt, dass die zum Strömungsantrieb des im Sekundärkreislauf zirkulierenden Kühlmittels benötigte Strömungsenergie auf diesem Wege eingekoppelt wird.

In konkreter Ausgestaltung kann es sich dabei gemäß Anspruch 6 um einen von der im Primärkühlkreis angeordneten Primärturbine angetriebenen Magneten handeln, der einen, vorzugsweise baugleichen, anderen Magneten, der im Sekundärkühlkreis angeordnet ist, antreibt, wobei der auf diese Weise angetriebene Magnet dann eine im Sekundärkühlkreislauf angeordneten Sekundärturbine antreibt, die das im Sekundärkühlkreislauf angeordnete Kühlmittel bestimmungsgemäß zirkulieren lässt.

In einer alternativen Ausgestaltung kann auch die im Primärkühlkreislauf angeordnete Primärturbine selbst magnetisch ausgebildet sein, um so die im Sekundärkühlkreislauf angeordneten Sekundärturbine, die vorzugsweise baugleich ausgelegt ist, anzutreiben und so eine direkte magnetische Kopplung zwischen Primärturbine im Primärkühlkreislauf und Sekundärturbine im Sekundärkühlkreislauf zu schaffen. Auch in diesem Falle ist der Strömungsantrieb des Kühlmittels im Sekundärkühlkreislauf über eine magnetische Kopplung mit dem Primärkühlkreislauf realisiert.

In alternativer Ausgestaltung kann der Strömungsantrieb des Sekundärkühlkreises auch aufgrund einer mechanischen Kopplung über ein an sich herkömmliches Getriebe erfolgen. Hierzu ist die im Sekundärkühlkreislauf angetriebene Sekundärturbine über eine Abtriebswelle mit einer Antriebswelle der Primärturbine, die im Primärkühlkreislauf angeordnet ist, wirkverbunden.

In weiter verbesserter Ausführung sind im Primär- und/oder Sekundärkühlkreislauf Druckregler oder zumindest Druckminderer angeordnet, um gegebenenfalls aufgrund von Spannungsschwankungen auftauchende Druckschwankungen ausgleichen zu können bzw. einen wirksamen Überdruckschutz für den nachgeschalteten Primär- bzw. Sekundärkühlkreis sicherzustellen. Nachdem die Wärmeaufnahmekapazität des in den Kühlkreisläufen angeordneten Kühlmittels unter anderem auch von dem in dem Kühlkreislauf herrschenden Druck abhängt, stellen die genannten Regler darüber hinaus ein Stellglied zur Regelung des Kühlkreislaufs auch in thermischer Hinsicht dar.

Alternativ oder zusätzlich kann einem oder beiden der genannten Kreisläufe auch ein Drehzahlregler zugeordnet sein, der auf die Primärturbine bzw. auf die Sekundärturbine einwirkt. Letztlich stellen auch diese Regler Stellglieder zur Regelung des Druckhaushalts und damit des Wärmehaushalts der Kühlkreisläufe dar.

Die Effizienz des Kühlkreislaufs hängt ganz wesentlich vom Wärmeübergang vom Sekundärkühlkreis zum Primärkühlkreis ab, wobei sich als vorteilhaft erwiesen hat, wenn zumindest eine der beiden Kontaktflächen elastisch ausgebildet ist, um somit eine möglichst perfekte Anlage im Bereich dieser Kontaktflächen zum Zwecke eines verbesserten Wärmeübergangs zu erreichen.

Dies kann beispielsweise in einfacher Weise dadurch erreicht werden, dass eine der beiden Kontaktflächen als Aluminium-Druckgussteil gefertigt ist.

Der Wärmeübergang in diesem Bereich kann dadurch weiter verbessert werden, dass die Kontaktflächen unter Zwischenlage einer diesem Bereich nachträglich oder bereits werkseitig eingebrachten Wärmeleitpaste erfolgt.

Ferner kann im Primär- und/oder Sekundärkühlkreislauf zusätzlich jeweils ein Ausgleichsbehälter angeordnet sein, um etwaige Überdrücke zu vermeiden. Der Ausgleichsbehälter stellt ein passives Sicherheitselement dar, das zumindest dann sinnvoll ist, wenn der Einbauraum einen solchen Ausgleichsbehälter zulässt.

Das Kühlmittel des Sekundärkreislaufs durchströmt einen dem Prozessor zugeordneten Kühlkörper der über eine Wärmetauschfläche die Abwärme des Prozessors an den Kühlkörper und das Kühlmittel abgibt. Dabei kann die Kühlleistung des Kühlkörpers dadurch vergrößert werden, dass die der Wärmetauschfläche abgewandete Oberfläche des Kühlkörpers durch entsprechende Bohrungen vergrößert ist.

Der Kühlkörper selbst ist mit Vorteil aus gesinterten Kupfer hergestellt

Die Erfindung wird nachstehend anhand eines in der Zeichnung nur schematisch dargestellten Ausführungsbeispiels näher erläutert.

Es zeigt:

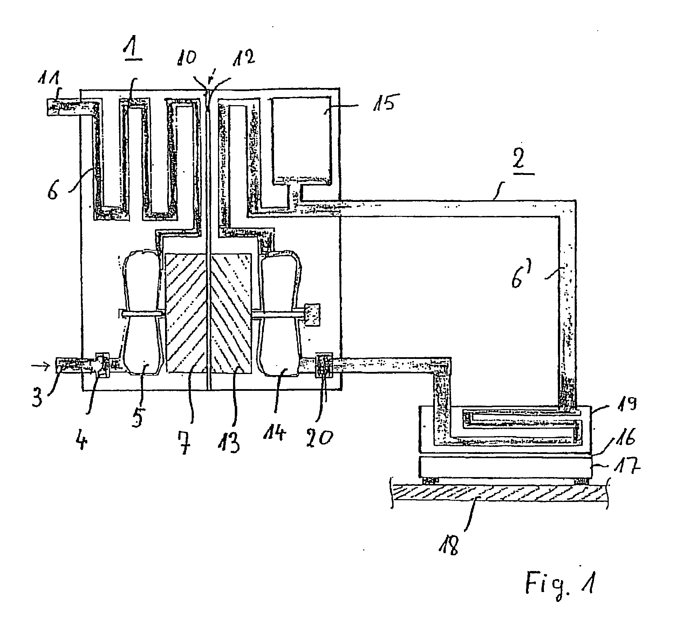

- Fig. 1:: ein Wärmetauschsystem in einer Prinzip- skizze.

Gemäss dem in Figur 1 dargestellten Prinzipbild besteht das Wärmetauschsystem aus einem Primärkühlkreislauf 1 und einem Sekundärkühlkreislauf 2, die zumindest im Wesentlichen baugleich ausgeführt sind. Der Primärkühlkreislauf 1 besteht im Wesentlichen aus einem Vorlauf 3, der unter Zwischenschaltung eines Druckminderers 4 zu einer Primärturbine 5 gelangt, die von der in dem Primärkühlkreislauf 1 befindlichen Kühlflüssigkeit 6 angetrieben wird. Der eigentliche Strömungsantrieb des Primärkühlkreislaufs 1 ist in der Zeichnung nicht dargestellt.

Üblicherweise wird ein zentraler Antrieb mehrere Primärkreisläufe bedienen. Auf gleicher Welle mit der Primärturbine 5 ist eine drehbare Magnetscheibe 7 angeordnet. Das die Primärturbine 5 in Rotation versetzende Kühlmittel 6 gelangt dann nach dem Durchströmen einer Kontaktfläche 10 zu einem Rücklauf 11. Dabei kann es im Rahmen dieses Ausführungsbeispiels offen bleiben, ob dem Primärkühlkreislauf 1 weitere Primärkühlkreisläufe in Reihe geschaltet sind.

Es ist einstweilen für die Beschreibung des Ausführungsbeispiels auch nicht weiter von Interesse, ob der Primärkühlkreislauf 1 als ein geschlossenes oder offenes System ausgebildet ist.

Der im Wesentlichen baugleich ausgebildete Sekundärkühlkreislauf 2 ist über die weitere Kontaktfläche 12 thermisch an den Primärkühlkreislauf 1 angekoppelt. Die Kontaktflächen 10 und 12 können jeweils elastisch ausgebildet sein, um eine möglichst gute Ankopplung der Kontaktflächen 10 und damit einen möglichst guten Wärmeübergang zu gewährleisten. Zwischen den beiden Kontaktflächen 10 und 12 kann überdies in hier nicht weiter dargestellter Weise eine Wärmeleitpaste eingebracht sein, um den Wärmeübergang noch weiter zu verbessern.

Darüber hinaus ist der Sekundärkühlkreislauf 2 jedoch über eine weitere Magnetscheibe 13, die im Sekundärkühlkreislauf 2 angeordnet ist, kontaktfrei induktiv an den Strömungsantrieb des Primärkühlkreislaufs 1 gekoppelt. Die Magnetscheiben 7 und 13 sind in dem hier vorliegenden Beispiel baugleich gefertigt. Um jedoch eine Über- oder Untersetzung der Antriebe zu erreichen, können durchaus auch unterschiedlich aufgebaute Magnetscheiben 7 und 13 oder eine abweichende Magnetisierung der Scheiben zum Einsatz gelangen. Auf gleicher Welle mit der weiteren Magnetscheibe 13 ist im Sekundärkühlkreislauf 2 eine Sekundärturbine 14 angeordnet, die dadurch angetrieben ist, dass die rotierende Magnetscheibe 7 die weitere Magnetscheibe 13 des Sekundärkühlkreislaufs 2 mitnimmt und somit die auf gleicher Welle angeordneten Sekundärturbine 14 antreibt. Das von der Sekundärturbine 14 angetriebene Kühlmittel 6' gelangt unter Zwischenschaltung eines Ausgleichsbehälters 15, der selbstverständlich zusätzlich auch im Primärkühlkreislauf 1 angeordnet sein könnte, zu einer Wärmeaustauschfläche 16 eines Kühlkörpers 19, der einem Prozessor 17 auf einer Leiterplatte 18 zugeordnet ist. Selbstverständlich könnten in den Sekundärkühlkreislauf 2 auch weitere Wärmeaustauschflächen vorgesehen sein bzw. die Wärmeaustauschfläche 16 mehreren Prozessoren 17 zugeordnet sein. Schließlich gelangt das im Sekundärkühlkreislauf 2 zirkulierende Kühlmittel 6' über einen weiteren Druckminderer 20 zurück zu der in Strömungsrichtung nachgeschalteten Sekundärturbine 14.

Nachstehend wird noch einmal die Funktion des vorstehend beschriebenen Wärmetauschsystems kurz erläutert:

Im Primärkühlkreis 1 ist eine extern angetriebene Primärturbine 5 angeordnet, die eine auf gleicher Welle sitzende Magnetscheibe 7 antreibt, die im Wege der magnetischen Kopplung über eine weitere, aber im Sekundärkühlkreislauf 2 angeordnete Magnetscheibe 13 eine im Sekundärkühlkreislauf 2 angeordnete Sekundärturbine 14 antreibt, so dass hierdurch der Strömungsantrieb für das im Sekundärkühlkreislauf 2 zirkulierende Kühlmittel 6' gewährleistet ist. Der Sekundärkühlkreislauf 2 ist somit als komplett geschlossenes System mit einem passiven Antrieb, der allein durch magnetische Kopplung vermittelt wird, ausgestattet. Der Sekundärkühlkreislauf 2 kann daher als separate Einschubeinheit oder aber als integraler Bestandteil eines Einschubteils für eine Hochleistungsprozessoreinheit, etwa für ein Rack, gestaltet sein.

Vorstehend ist somit ein Wärmetauschsystem mit einem passiven Sekundärkühlkreislauf verwirklicht, der es ermöglicht, flüssigkeitsgekühlte Kühlsysteme unproblematisch in Racks einzusetzen, nachzurüsten und gegebenenfalls auszutauschen. Insbesondere der Sekundärkühlkreislauf 2 ist dadurch weitgehend wartungsfrei, dass er keine aktiven Elemente enthält.

### BEZUGSZEICHENLISTE

- 1: Primärkühlkreislauf
- 2: Sekundärkühlkreislauf
- 3: Vorlauf
- 4: Druckminderer
- 5: Primärturbine
- 6, 6': Kühlmittel
- 7: Magnetscheibe
- 10: Kontaktfläche
- 11: Rücklauf
- 12: Weitere Kontaktfläche
- 13: Weitere Magnetscheibe
- 14: Sekundärturbine
- 15: Ausgleichsbehälter
- 16: Wärmetauschfläche
- 17: Prozessor
- 18: Leiterplatte
- 19: Kühlkörper
- 20: Weiterer Druckminderer

## Patentansprüche

1. Wärmetauschsystem für elektronische Geräte, vorzugsweise Datenverarbeitungsgeräte, mit Hochleistungsprozessoren bzw. mit einer hohen Prozessordichte, mit wenigstens einem Primärkühlkreis (1) und wenigstens einem Sekundärkühlkreis (2), die derart thermisch gekoppelt sind, dass die vom Sekundärkühlkreis (2) aufgenommene Wärme, vorzugsweise Prozessorenabwärme, im Wege des Wärmetauschs jeweils wenigstens über eine Kontaktfläche (10) zumindest weitgehend an den oder die Primärkühlkreis(e) abgegeben wird bzw. werden und mittels des bzw. der Primärkühlkreis(e) abgeführt und/oder abgekühlt wird bzw. werden, **dadurch gekennzeichnet, dass**
das Kühlmittel (6) des wenigstens einen Primärkühlkreis (1) mittels eines Strömungsantriebs im Primärkühlkreis (1) befördert wird, wobei dieser Strömungsantrieb mechanisch und/oder induktiv - ferromagnetisch oder elektromagnetisch - mit dem bzw. den Sekundärkühlkreis(en) (2) derart gekoppelt ist bzw. sind, dass hierdurch ein passiver Strömungsantrieb für das if Sekundärkreis (2)zu befördernde Kühlmittel (6') gegeben ist, wobei die Kühlmittel (6 und 6') der beiden Kühlkreise (1 und 2) unterscheidbar und strömungstechnisch voneinander getrennt sind.

2. Wärmetauschsystem nach Anspruch 1, **dadurch gekennzeichnet, dass** der bzw. die Sekundärkühlkreis(e) (2) als geschlossenes System ohne eigenen aktiven Strömungsantrieb ausgelegt ist bzw. sind.

3. Wärmetauschsystem nach Anspruch 2, **dadurch gekennzeichnet, dass** der bzw. die Sekundärkühlkreis(e) (2) jeweils als separate Einschubelemente für ein Rack oder als integraler Bestandteil eines mit einer Prozessoreinheit (17) versehenen Einschubs für ein Rack ausgebildet ist bzw. sind, wobei einem jedem Sekundärkühlkreis (2) eine oder mehrere Prozessoreinheit(en) zugeordnet sind.

4. Wärmetauschsystem nach einem der vorhergehenden Ansprüche, **dadurch gekennzeichnet, dass** der Strömungsantrieb des Primärkühlkreises (1) eine Primärturbine (5) mit einem angeschlossenen Kopplungselement antreibt, wobei dieses Kopplungselement zur ferromagnetischen Einkopplung der zum Antrieb des Kühlmittels (6') im Sekundärkreislauf (2) benötigten Strömungsenergie dient.

5. Wärmetauschsystem nach Anspruch 4, **dadurch gekennzeichnet, dass** das im Primärkühlkreis (1) angeordnete Kopplungselement ein von der Primärturbine (5) mechanisch angetriebener Magnet (7) ist, der einen, vorzugsweise baugleichen, anderen Magneten (13), der in jeweils jedem diesem Primärkühlkreislauf (1) zugeordneten Sekundärkühlkreis (2) angeordnet ist/sind, mitnimmt, wobei der oder die anderen Magnet(en) (13) jeweils eine im Sekundärkühlkreis (2) angeordnete Sekundärturbine (14) zum Antrieb des im Sekundärkühlkreislauf (2) zu befördernden Kühlmittels (6') antreibt.

6. Wärmetauschsystem nach einem der vorhergehenden Ansprüche 1 bis 3, **dadurch gekennzeichnet, dass** die Primärturbine (5) des Primärkühlkreislaufs (1) als rotierendes magnetisches Schaufelrad ausgebildet ist, die eine, vorzugsweise baugleiche, ebenfalls als magnetisches Schaufelrad ausgestaltete Sekundärturbine (14) im jeweiligen Sekundärkühlkreislauf (2) antreibt.

7. Wärmetauschsystem nach einem der vorhergehenden Ansprüche 1 bis 3, **dadurch gekennzeichnet, dass** der Strömungsantrieb des Primärkühlkreislaufs (1) mit dem Strömungsantrieb des Sekundärkühlkreises (2) derart mechanisch gekoppelt ist, dass die im Primärkühlkreis (1) angeordnete Primärturbine (5) über eine, vorzugsweise abgedichtete, stumpfe Antriebswelle mit einer Abtriebswelle, die dem Sekundärkühlkreislauf (2) zugeordnet ist, verzahnt und/oder übersetzt ist, wobei mittels dieser Abtriebswelle die im Sekundärkühlkreis (2) jeweils angeordnete Sekundärturbine (14) angetrieben ist.

8. Wärmetauschsystem nach einem der vorhergehenden Ansprüche, **dadurch gekennzeichnet, dass** im Primär- und/oder Sekundärkühlkreislauf (1, 2) wenigstens ein Druckregler und/oder wenigstens ein Druckminderer (4, 20), vorzugsweise in Strömungsrichtung, vor der Primär- bzw. Sekundärturbine (5, 14) angeordnet ist.

9. Wärmetauschsystem nach einem der vorhergehenden Ansprüche, **dadurch gekennzeichnet, dass** im Primär- und/oder Sekundärkühlkreislauf (1, 2) wenigstens ein Drehzahlregler und/oder Drehzahlminderer der Primär- und/oder Sekundärturbine (5, 14) zugeordnet ist.

10. Wärmetauschsystem nach einem der vorherstehenden Ansprüche, **dadurch gekennzeichnet, dass** wenigstens eine der beiden Kontaktflächen (10, 12) zur Ausbildung des Wärmeübergangs vom Sekundärkühlkreis (2) zum Primärkühlkreis (1) elastisch ausgebildet ist.

11. Wärmetauschsystem nach Anspruch 10, **dadurch gekennzeichnet, dass** zumindest eine der Kontaktflächen (10, 12) als Aluminium-Druckgussteil gefertigt ist.

12. Wärmetauschsystem nach Anspruch 10 oder 11, **dadurch gekennzeichnet, dass** der Wärmeübergang im Bereich der Kontaktflächen (10, 12) unter Zwischenlage einer zwischen den Kontaktflächen (10, 12) eingebrachten Wärmeleitpaste verbessert ist.

13. Wärmetauschsystem nach einem der vorhergehenden Ansprüche, **dadurch gekennzeichnet, dass** im Primär- und/oder Sekundärkühlkreislauf (1, 2) jeweils ein Ausgleichsbehälter (15) angeordnet ist.

14. Wärmetauschsystem nach einem der vorhergehenden Ansprüche, **dadurch gekennzeichnet, dass** der Prozessoreinheit (17) wenigstens ein Kühlkörper (19) zugeordnet ist, wobei der Kühlkörper (19) hierzu mit Bohrungen versehen ist, durch die das Kühlmittel (6') des Sekundärkreislaufs (2) strömt.

15. Wärmetauschsystem nach Anspruch 14 dass der Kühlkörper (19) auf der der Prozessoreinheit (16) zugewandten Seite mit einer thermisch leitenden Wärmetauschfläche (16) versehen ist, die allenfalls mit einigen größeren Bohrungen versehen ist, und der Kühlkörper (19) auf der der Wärmetauschfläche (16) abgewandten Oberfläche mit einer Vielzahl von Bohrungen kleineren Durchmessers versehen ist.

16. Wärmetauschsystem nach Anspruch 14 oder 15, **dadurch gekennzeichnet, dass** der Kühlkörper (19) aus gesintertem Kupfer hergestellt ist.

## Claims

1. A heat exchange system for electronic devices, preferably data processing devices, having high-performance processors or having a high processor density, respectively, having at least one primary cooling circuit (1) and at least one secondary cooling circuit (2), which are thermally coupled in such a manner that the heat, preferably processor waste heat, which is absorbed by the secondary cooling circuit (2) is at least substantially discharged to the primary cooling circuit(s) by way of heat exchange respectively at least via one contact surface (10) and is dissipated and/or cooled using the primary cooling circuit(s),
**characterized in that**
the coolant (6) of the at least one primary cooling circuit (1) is conveyed using a flow drive in the primary cooling circuit (1), this flow drive being mechanically and/or inductively - ferromagnetically or electromagnetically - coupled to the secondary cooling circuit(s) (2) in such a manner that a passive flow drive is thus provided for the coolant (6') to be conveyed in the secondary circuit (2), the coolants (6 and 6') of the two cooling circuits (1 and 2) being differentiable and separated from one another in flow technology.

2. The heat exchange system according to Claim 1, **characterized in that** the secondary cooling circuit(s) (2) is/are designed as a closed system without separate active flow drive.

3. The heat exchange system according to Claim 2, **characterized in that** the secondary cooling circuit(s) (2) is/are respectively formed as separate insert elements for a rack or as an integral component of an insert, which is provided with a processor unit (17), for a rack, one or more processor unit(s) being assigned to each secondary cooling circuit (2).

4. The heat exchange system according to one of the preceding claims, **characterized in that** the flow drive of the primary cooling circuit (1) drives a primary turbine (5) having a connected coupling element, this coupling element being used for the ferromagnetic coupling of the flow energy required for driving the coolant (6') in the secondary cooling circuit (2).

5. The heat exchange system according to Claim 4, **characterized in that** the coupling element, which is situated in the primary cooling circuit (1), is a magnet (7), which is mechanically driven by the primary turbine (5), and which entrains another magnet (13), which is preferably structurally identical and is/are situated in each respective secondary cooling circuit (2) assigned to this primary cooling circuit (1), the other magnet(s) (13) respectively driving a secondary turbine (14), which is situated in the secondary cooling circuit (2), to drive the coolant (6') to be conveyed in the secondary cooling circuit (2).

6. The heat exchange system according to one of the preceding Claims 1 to 3, **characterized in that** the primary turbine (5) ofthe primary cooling circuit (1) is formed as a rotating magnetic blade wheel, which drives a secondary turbine (14), which is preferably structurally identical and is also designed as a magnetic blade wheel, in the respective secondary cooling circuit (2).

7. The heat exchange system according to one of the preceding Claims 1 to 3, **characterized in that** the flow drive of the primary cooling circuit (1) is mechanically coupled to the flow drive of the secondary cooling circuit (2) in such a manner that the primary turbine (5), which is situated in the primary cooling circuit (1), is meshed and/or transmitted via a stub drive shaft, which is preferably sealed, with an output shaft, which is assigned to the secondary cooling circuit (2), the respective secondary turbine (14), which is situated in the secondary cooling circuit (2), being driven using this output shaft.

8. The heat exchange system according to one ofthe preceding claims, **characterized in that** at least one pressure regulator and/or at least one pressure reducer (4, 20) is situated in the primary and/or secondary cooling circuit (1, 2), preferably in the flow direction before the primary or secondary turbine (5, 14), respectively.

9. The heat exchange system according to one of the preceding claims, **characterized in that** at least one speed regulator and/or speed reducer is assigned to the primary and/or secondary turbine (5, 14) in the primary and/or secondary cooling circuit (1, 2).

10. The heat exchange system according to one of the preceding claims, **characterized in that** at least one ofthe two contact surfaces (10, 12) for forming the heat transfer from the secondary cooling circuit (2) to the primary cooling circuit (1) is elastic.

11. The heat exchange system according to Claim 10, **characterized in that** at least one of the contact surfaces (10, 12) is manufactured as an aluminum die-cast part.

12. The heat exchange system according to Claim 10 or 11, **characterized in that** the heat transfer is improved in the area of the contact surfaces (10, 12) with a heat conduction paste interposed, which is introduced between the contact surfaces (10, 12).

13. The heat exchange system according to one of the preceding claims, **characterized in that** a compensation container (15) is situated respectively in the primary and/or secondary cooling circuit (1, 2).

14. The heat exchange system according to one of the preceding claims, **characterized in that** at least one cooling body (19) is assigned to the processor unit (17), the cooling body (19) being provided with drilled holes for this purpose, through which the coolant (6') of the secondary circuit (2) flows.

15. The heat exchange system according to Claim 14, **characterized in that** the cooling body (19) is provided with a thermally conductive heat exchange surface (16), which is provided with several larger drilled holes if any, on the side facing toward the processor unit (17), and the cooling body (19) is provided with a multitude of drilled holes of smaller diameter on the surface facing away from the heat exchange surface (16).

16. The heat exchange system according to Claim 14 or 15, **characterized in that** the cooling body (19) is produced from sintered copper.

## Revendications

1. Système d'échange de chaleur pour appareils électroniques, de préférence appareils de traitement de données, avec des processeurs de grande puissance ou avec une grande densité de processeurs, avec au moins un circuit de refroidissement primaire (1) et au moins un circuit de refroidissement secondaire (2) qui sont couplés thermiquement de telle façon que la chaleur absorbée par le circuit de refroidissement secondaire (2), de préférence la chaleur d'échappement des processeurs, soit au moins en grande partie transférée par échange de chaleur respectivement par au moins une surface de contact (10) au(x) circuit(s) de refroidissement primaire(s) et évacuée et/ou refroidie au moyen du ou des circuit(s) de refroidissement primaire(s),
**caractérisé en ce que** le fluide réfrigérant (6) de l'au moins un circuit de refroidissement primaire (1) est transporté au moyen d'un entraînement de circulation dans le circuit de refroidissement primaire (1), lequel entraînement de circulation est couplé mécaniquement et/ou par induction - ferromagnétique ou électromagnétique - avec le ou les circuit(s) de refroidissement secondaire(s) (2) de façon à créer un entraînement de circulation passive pour le fluide réfrigérant (6') à transporter dans le circuit secondaire (2), les fluides réfrigérants (6 et 6') des deux circuits de refroidissement (1 et 2) pouvant être différenciés et étant séparés l'un de l'autre au niveau de la circulation.

2. Système d'échange de chaleur selon la revendication 1, **caractérisé en ce que** le ou les circuit(s) de refroidissement secondaire(s) (2) est ou sont conçu(s) comme un système fermé sans entraînement d'écoulement actif propre.

3. Système d'échange de chaleur selon la revendication 2, **caractérisé en ce que** le ou les circuit(s) de refroidissement secondaire(s) (2) est ou sont conçu(s) chacun comme des éléments de tiroir séparés pour un rack ou comme une partie intégrante d'un tiroir muni d'une unité de processeur (17) pour un rack, chaque circuit de refroidissement secondaire (2) étant associé à une ou plusieurs unités de processeur.

4. Système d'échange de chaleur selon l'une des revendications précédentes, **caractérisé en ce que** l'entraînement de circulation du circuit de refroidissement primaire (1) entraîne une turbine primaire (5) à laquelle un élément de couplage est raccordé, lequel élément de couplage servant au couplage ferromagnétique de l'énergie d'écoulement nécessaire pour entraîner le fluide réfrigérant (6') dans le circuit secondaire (2).

5. Système d'échange de chaleur selon la revendication 4, **caractérisé en ce que** l'élément de couplage disposé dans le circuit de refroidissement primaire (1) est un aimant (7) entraîné mécaniquement par la turbine primaire (5), qui entraîne un autre aimant (13), de préférence de construction identique, qui est/sont disposé(s) respectivement dans chaque circuit de refroidissement secondaire (2) associé au circuit de refroidissement primaire (1), le ou les autre(s) aimant(s) (13) entraînant chacun une turbine secondaire (14) disposée dans le circuit de refroidissement secondaire (2) pour entraîner le fluide réfrigérant (6') à transporter dans le circuit de refroidissement secondaire (2).

6. Système d'échange de chaleur selon l'une des revendications 1 à 3, **caractérisé en ce que** la turbine primaire (5) du circuit de refroidissement primaire (1) est conçue comme une roue à aubes magnétique rotative, qui entraîne une turbine secondaire (14), de préférence de construction identique, également conformée comme une roue à aubes magnétique, dans le circuit de refroidissement secondaire (2) correspondante.

7. Système d'échange de chaleur selon l'une des revendications 1 à 3, **caractérisé en ce que** l'entraînement de circulation du circuit de refroidissement primaire (1) est couplé mécaniquement à l'entraînement de circulation du circuit de refroidissement secondaire (2) de telle façon que la turbine primaire (5) disposée dans le circuit de refroidissement primaire (1) engrène et/ou est multipliée par l'intermédiaire d'un arbre d'entraînement émoussé, de préférence étanche, avec un arbre de sortie associé au circuit de refroidissement secondaire (2), cet arbre de sortie entraînant la turbine secondaire (14) disposée dans chaque circuit de refroidissement secondaire (2).

8. Système d'échange de chaleur selon l'une des revendications précédentes, **caractérisé en ce qu'**au moins un régulateur de pression et/ou au moins un réducteur de pression (4, 20) est disposé dans le circuit de refroidissement primaire ou secondaire (1, 2), disposé de préférence avant la turbine primaire ou secondaire (5, 14) dans le sens de l'écoulement.

9. Système d'échange de chaleur selon l'une des revendications précédentes, **caractérisé en ce qu'**au moins un régulateur de vitesse de rotation et/ou un réducteur de vitesse de rotation est associé à la turbine primaire et/ou secondaire (5, 14) dans le circuit de refroidissement primaire et/ou secondaire (1, 2).

10. Système d'échange de chaleur selon l'une des revendications précédentes, **caractérisé en ce qu'**au moins une des deux surfaces de contact (10, 12) destinées à créer la transition thermique du circuit de refroidissement secondaire (2) au circuit de refroidissement primaire (1) est élastique.

11. Système d'échange de chaleur selon la revendication 10, **caractérisé en ce qu'**au moins une des surfaces de contact (10, 12) est fabriquée sous la forme d'une pièce en aluminium moulée sous pression.

12. Système d'échange de chaleur selon la revendication 10 ou 11, **caractérisé en ce que** la transition de chaleur au niveau des surfaces de contact (10, 12) est améliorée par l'intercalation d'une pâte thermique introduite entre les surfaces de contact (10, 12).

13. Système d'échange de chaleur selon l'une des revendications précédentes, **caractérisé en ce qu'**un réservoir de compensation (15) est disposé dans le circuit de refroidissement primaire et/ou secondaire (1, 2).

14. Système d'échange de chaleur selon l'une des revendications précédentes, **caractérisé en ce qu'**au moins un radiateur (19) est associée à l'unité de processeur (17), lequel radiateur (19) étant muni pour cela de trous percés à travers lesquels circule le fluide réfrigérant (6') du circuit secondaire (2).

15. Système d'échange de chaleur selon la revendication 14, **caractérisé en ce que** le radiateur (19) est muni sur sa face tournée vers l'unité de processeur (17) d'une surface d'échange de chaleur (16) conductrice thermique, qui peut être munie éventuellement de quelques trous percés plus grands, et le radiateur (19) est muni sur la surface opposée à la surface d'échange de chaleur (16) d'une pluralité de trous percés de plus petit diamètre.

16. Système d'échange de chaleur selon la revendication 14 ou 15, **caractérisé en ce que** le radiateur (19) est fabriqué à partir de cuivre fritté.
